# EUROPEAN PATENT APPLICATION

(11) **EP 3 242 336 A1**
(43) Date of publication of application: **08.11.2017**
(21) Application number: 17162933.0
(22) Date of filing: 24.03.2017
(51) Int. Cl.: H01L 33/16, H01L 31/036

(54) **LIGHT EMITTING STRUCTURES AND SYSTEMS ON THE BASIS OF GROUP-IV MATERIALS FOR THE ULTRAVIOLET AND VISIBLE SPECTRAL RANGES BASED ON SURFACE PLASMONS AND SURFACE PLASMON POLARITONS**

(30) Priority: 26.04.2016 GB 201607684
(71) Applicant: Lavchiev, Ventsislav, 4210 Gallneukirchen (AT)
(72) Inventor: Lavchiev, Ventsislav, 4210 Gallneukirchen (AT)

(57) **Abstract**

The invention disclosure relates to emission of ultraviolet and/or visible light by highly crystalline material structures, systems and devices under excitation by a light beam, by an electron beam, by voltage bias or by THz radiation. The light emission is linked to bulk and surface plasmons in the materials and their interfaces, and to bulk and surface plasmon polaritons which are surface plasmons coupled to intraband and interband transitions of the electrons and holes in the valence band and conduction band of the semiconductor, to the coupling between the surface plasmons/polaritons and the particles generated in the intraband and interband transitions. The light emission can be linked to a doping level, if one (or both) of the interfacing materials is doped, or to the oxygen related states on the Si and Ge interfaces with their oxides.

The light emission, however, cannot happen without the presence of at least one of the following quasi-particles: surface plasmons, surface plasmon polaritons, bulk plasmons and/or bulk plasmon polaritons, which develop in the bulk of the semiconductor material or at the surface of the semiconductor material (which is the interface of the material with another material or another phase of the same material). This is distinguished characteristic of the present invention as compared to the conventional light emitting diodes, laser diodes or lasers based on semiconductor materials. The existing to date light emitters produce light due to net interband or intraband transitions of carriers and do not require the presence of plasmons or polaritons; and the tuning of the wavelength of their light emission cannot be done by the methods described in Claims 9 and 10 here.

The bulk and the surface plasmons are oscillations of electrons of the material in resonance with the excitation light, electron beam, terahertz radiation or electric bias. However, in the semiconductor materials (e.g. Si or Ge here), electrons from the conduction band (CB) or from the valence band (VB) can be involved (or simultaneously both - electrons from CB and from VB). Typically, the VB electrons are of much higher density than CB electrons whatever the doping is applied to increase the density of CB electrons. For this reason, plasmons and plasmon polaritons with VB electrons are always more efficient and easier to achieve.

A conventional device based on this effect will contain several units.
The input unit is a source of light, of voltage/current, of an electron beam or of terahertz radiation. The active unit is a material structure containing one or more layers of the materials described in the body text of the invention. The system may include a passive unit such as a ring resonator, a waveguide, coupler, a grating or else for light amplification. Additional units such as a control unit, readout unit or else may be also incorporated.

## Description

### FIELD

The present disclosure generally relates to emission of light by highly crystalline materials, structures and devices fabricated and designed in a specific manner allowing for such light emission. The light emission, taking place in the ultraviolet UV and visible spectral ranges, is linked to bulk and surface plasmons and plasmon polaritons in the materials and their interfaces, to the intraband and interband transitions of the electrons and holes in the valence band and conduction band, to the coupling between the surface plasmons/polaritons and the particles generated in the intraband and interband transitions. The light emission, however, cannot happen without the presence of at least one of the following quasi-particles: surface plasmons, surface plasmon polaritons, bulk plasmons and/or bulk plasmon polaritons, which develop in the bulk of the semiconductor material or at the surface of the semiconductor material (which is the interface of the material with another material or another phase of the same material).

**Note:** Though the similarity, there are two fundamental differences between the existing and the reported to date light emitters based on semiconductor materials like Si and Ge and the light emitters introduced in this invention disclosure:
(i) In this invention, the presence of plasmon/plasmon polariton is a prerequisite for the light emission to take place. The light emission always occurs at a frequency (respectfully, wavelength) dependent on the frequency of the plasmon/plasmon polariton. The frequency of the emitted light is in resonance with the frequency of the plasmon/plasmon polariton. This is important fundamental physical difference between the existing light emitters such as the Si- or Ge-based diodes and the light emitters described here. In this respect, the light emitters, presented in this invention disclosure, are plasmonic or polaritonic light emitters, as they can be referred to; the light is emitted as a result of (i) either direct relaxation of the plasmons/plasmon polaritons or (ii) the plasmons/plasmon polaritons mediate (induce) a carrier relaxation at resonant frequencies (wavelengths) with emission of photons (light). In contrast, the existing and previously reported light emitters emit light due to net electron or hole transitions between the electron/hole bands.
(ii) The frequency of the plasmonic /polaritonic light emitters can be tuned (a) by tuning the dielectric functions of the materials, (b) in case of plasmon polaritons, by tuning the frequency of the plasmon to some of the band transitions of the semiconductor, not necessarily at the *Γ*-point (Gamma-point) on the band diagram. (c) by other methods as well.
(iii) The bulk and the surface plasmons are oscillations of electrons of the material in resonance with the excitation (light, electron beam, terahertz THz radiation or electric bias). However, in the semiconductor materials (e.g. Si or Ge here), electrons from the conduction band (CB) or from the valence band (VB) can be involved (or simultaneously both types). Typically, the VB electrons are of much higher density than CB electrons whatever the doping is applied to increase the density of CB electrons. For this reason, plasmons and plasmon polaritons with VB electrons are always more efficient and easier to achieve.

### BACKGROUND

Light emitters are material, structures or devices capable of emission of light when voltage or light of another wavelength or electron beam is applied to them. One type of light emitters is the emitters of visible light such as broadband lamps (in terms of spectral width of the emission). Another type of light emitter emits narrow spectral light such as light emitting diodes (LED), organic LED (OLED), quantum dot LED (QDLED). Another type of light source is the laser and the laser diode, which is an emitter of coherent, narrow spectral light. Yet another type of emitters can emit light in ultra-violet or infrared spectral ranges. The typical LED, OLED, QDLED or laser (diode), which are the prevalent contemporary light emitters, are based on compound semiconductors from II-IV group, III-V group, group-IV or polymers capable of light emission.

The light emitters have a broad range of applications - for lighting, in TV screens, automobiles, data transmission, computers, radars, decoration, military, entertaining industry, night vision, sensor technologies, traffic control, in manufacturing or control in the manufacturing processes.

The typical LED, OLED, QDLED, laser diode and solid state laser, which are the prevalent contemporary light emitters, are based either (i) on polymers capable of light emission (luminescence) under excitation. Such are, for instance, the conductive polymers like MEH_PPV; (ii) or on semiconductor materials from the group-IV of the periodic table of elements and compound semiconductors from II-IV group, III-V group and group-IV.
These light sources produce light emission as a result of pure interband or intraband transitions of electrons and/or holes. In a semiconductor, interband transition is a transition between the conduction band, CB, and the valence band, VB. In polymers, this corresponds to a HOMO-LUMO transition (HOMO, highest occupied molecular orbital, LUMO lowest unoccupied molecular orbital). Interband transitions take place, for example, in LED, OLED, QDLED, laser diodes, interband cascade lasers (ICL) etc. Intraband is a transition between energy levels within the CB or within the VB. Intraband transitions are also called subband or intrasubband transitions. Intraband transitions take place, for instance, in quantum cascade lasers (QCL), VECSEL etc. The excitation of the particle (an electron or a hole) to an excited energy level is accomplished usually by applying of a voltage bias or by light. The emission of light occurs when the excited particle shifts from an excited energy level to a lower energy level the energy difference being emitted in the form of a photon (a quantum of light).

The electrical excitation is the most common type of excitation from application point of view. It is applied to heterostructures such as semiconductor heterostructures (thin layers), heterostructures with embedded semiconductor quantum dots, heterostructures with conductive polymers etc. The semiconductor heterostructure is based either on pn-junction or pin-junction; alternatively on any combination or multiplication of them.
In the pn-junction, a p-doped semiconductor interfaces an n-doped semiconductor. The two semiconductors are selected so that to have different bandgaps and form alignment of their bandgaps of type-I, type-II or type-III heterojunction. It is paid attention to that always the CB of one of the semiconductors is always lower than the CB of the other semiconductor, while the VB of the former can be lower (type-I) or higher (type-II and type-III) than the VB of the latter. The application of proper voltage bias (e.g. forward for LED) to the metal contacts, deposited on each the p-doped and the n-doped semiconductor, causes flow of electrons from the n-doped semiconductor toward the p-doped semiconductor and flow of holes from the p-doped semiconductor toward the n-doped semiconductor. During this current flow, when an electron meets a hole a process of an electron-hole recombination occurs resulting in emission of photons.
In the pin-junction, a p-doped semiconductor and an n-doped semiconductor are interposed by an undoped layer called intrinsic (i-semiconductor). All the three semiconductor layers have different bandgaps and the i-semiconductor must have a narrower bandgap than both the n-doped and the p-doped semiconductor. It is paid attention to that always the CB of the n-doped semiconductor lays higher than the CB of the i-layer; at the same time, the VB of the p-doped semiconductor lays lower than the VB of the i-semiconductor. This bands architecture enables easy drift of electrons from n-doped semiconductor into the i-semiconductor and drift of holes from the p-doped semiconductor into the i-semiconductor. As a result, the electrons and the holes are confined in the tiny intrinsic region, which ensures high probability of electron-hole recombination i.e. high efficiency of light emission.

All existing to date light emitters, mentioned above, are characterized by at least one of the following features - high power consumption, relatively high price, requirement of special technology for fabrication, use of relatively expensive materials for fabrication or non-compatibility to the silicon (Si)-based technology.

An efficient light source based on a group-IV material - silicon (Si), germanium (Ge), tin (Sn), lead (Pb), carbon (C, for instance silicon carbide SiC), erbium (Er) or a combination of them - would bring enormous advantages for the Si-based technology and the related industries. Such a light source will not only find applications in all the areas described in [002], but it can reshape the telecommunication-, the TV-fabrication, mobile phone- and computer industries. Of a special importance is the fact that a single-chip integration of a light source, a photodetector and a passive structure (a waveguide, a resonator, a Mach-Zender interferometer etc.) all based on group-IV materials will be possible. This integration will result in a drastic increase of device functionalities, reduction of fabrication costs, boost of device speed, further miniaturization of the devices etc. Least, but not last, Si is the most abundant material in the Earth crust, which makes it an unlimited resource for the opto-electronics and the next generation photonics devices.

However, bulk Si and Ge are poor, unefficient light emitters. The reason of this is that they have an indirect electron bandgap structure. I.e. in the plot of the energy *E* of a particle (an electron or a hole) against the momentum ***k*** of the particle *E(**k**),* the top of the VB, which is marked as gamma-point (*Γ*-point), and the bottom of the CB are located at different points regarding the x-axis (the ***k-***axis). The difference between the top of the VB and the bottom of the CB along the y-axis (energy axis) is the electron bandgap. Thus, when excitation is applied to the material, then an electron-hole pair is generated - the electron is excited to the CB leaving behind a hole in the VB. The electron and the hole may be initially excited to higher energy levels, but they scatter quickly via Stokes scattering to the bottom of the CB and the top of the VB, respectively, in order to minimize energy. At this moment, the holes being at the *Γ*-point possess minimum energy and zero momentum, whereas the electrons being at Δ-valley (delta-valley) in Si and at L-valley in Ge possess both non-zero energy *E* and momentum ***k***. For the electron-hole annihilation to occur, which causes an emission of a photon, the electron has to drop back to the VB by releasing both energy and momentum. This radiative process, however, is much slower and of less probability than other, non-radiative processes such as releasing the energy via emission of phonons (crystal lattice vibration, which finally ends up via heat emission).
Another way of expressing this process is by saying that radiative recombination of electrons and holes in bulk Si and Ge happens only for particles, for which the laws of energy and momentum conservation are simultaneously satisfied.

By contrast, in the direct bandgap materials such as the II-VI and III-V compound semiconductors GaAs, InP, GaN etc. which are widely used in the opto-electronics, the minimum point of energy both for the holes in the VB and the electrons in the CB is at the *Γ*-point i.e. electrons and holes possess no momentum. The laws of energy and momentum conservation are simultaneously satisfied and the recombination of the electron and the hole happens rapidly without the need of phonon emission. This makes the direct gap materials efficient light emitters. However, these direct gap materials are incompatible with the Si technology, which hinders the many advantages described in [006].

In order to overcome the obstacles associated with the indirect bandgap of Si and Ge, two basic approaches have been undertaken:
*A*. Nanostructures - Si and Ge can be fabricated in the form of nanostructures. These include quantum dots (zero-dimensional nano-objects), quantum wires or nanowires (one-dimensional) and nanolayers or quantum wells (two-dimensional nanoobjects). In such nanostructures, the electrons and the holes are confined to a very limited spatial region; this imposes restrictions on the values the momentum and the energy of the electrons and holes can have (so called quantum confinement effect). As a result, the probability of radiative electron-hole recombination is drastically increased.
*B*. Strain - Si and Ge have different lattice constants, that is different spacing between the atoms, which are organized in a crystal lattice. That is why, when Si is grown on Ge substrate (by molecular beam epitaxy, MBE, or by chemical vapor deposition, CVD) or vice versa, a physical strain appears in the lattice of the new crystal. Depending on the various parameters, this strain may be tensile or compressive. In both cases, the strain modifies the bandgap of the crystal; even to such extent that the Si or Ge can become a direct gap emitter. This phenomenon is exploited in the manipulation (increase) of the efficiency of the light emission from Si and Ge. Such modification of the electron bandgap can be achieved in heterostructures such as Si/Ge (silicon grown on germanium substrate), Ge/Si, Si₁₋ₓGeₓ/Si, Ge₁₋ₓSnₓ/Si, n-Ge/Si etc.

### SUMMARY OF THE INVENTION.

### PROBLEMS TO BE SOLVED BY THE INVENTION

Despite the achievements of both methods, described in [009], in increasing the efficiency of radiative electron-hole recombination, Si- and Ge-based structures remain with major disadvantages: the nanostructures are difficult to contact electrically and prone to strong oxidation. The oxide layer is an insulator, which further hinders the electrical contacting of the nanostructures, on the one hand, and harms the luminescence of the nanostructures via creating of additional channel for non-radiative recombination, the so called oxide electron traps. The efficiency of light emission of the direct bandgap compound semiconductors remains superior to that of Si- and Ge-based structures even under strain especially at room temperature. Such factors play a crucial role in the scant applicability of Si and Ge for light generation.

The present invention disclosure describes an efficient light emitter based on crystalline Si or Ge, which can be intrinsic or n- or p-doped, or combination of them or combination of anyone of them with its oxide phase or combination of them with antimony (Sb) or any doping. The materials are either in bulk form or in the form of thin layers.

The efficient light generation occurs in the presence of one of the following quasi-particles: (i) a bulk plasmon, (ii) a surface plasmon, (iii) a bulk plasmon polariton. (iv) a surface plasmon polariton.
I.e. a plasmon or a plasmon polariton must be generated (excited) in the material in order for light emission to occur.
The bulk and surface plasmons are collective oscillations of the electrons of a medium; the bulk plasmons occur in the volume of the medium, whereas the surface plasmons occur at the interface of two media. These collective oscillations happen at resonant frequencies (resonant wavelengths, respectively), which depend on the excitation frequency and the dielectric function of the medium (for bulk plasmons) or the dielectric functions of the two interfacing media (for surface plasmons).
The plasmon polariton is a mixture of a bulk/surface plasmon, the excitation beam/wave and an interband transition in the material.

Surface plasmons and surface plasmon polaritons develop only if an interface between two materials of different dielectric constants is present. Thus, two different materials, in terms of a dielectric constant, must form an interface. The surface plasmon/plasmon polariton is bound to the interface of the two media, its field extends into the two media, however it can propagate along the interface or can be localized.

In the following, only surface plasmons and surface plasmon polaritons will be discussed. However, similar considerations are valid for bulk plasmons and bulk plasmon polaritons, so this invention disclosure is equally valid for light emitters involving either surface or bulk plasmons/polaritons or a combination of bulk and surface plasmons/polaritons.

The excitation of surface plasmons is by means of an excitation light beam, an excitation electron beam, by means of electrical excitation or by means of THz (teraherz) waves.
A resonant condition for the wavevectors of the incident excitation beam/wave and the plasmons should be fulfilled in order for an effective excitation of plasmons to take place.

The light emission is a result of several possible mechanisms: (i) decay of the surface plasmon/surface plasmon polariton to a ground (unexcited) state; the energy difference is emitted as a photon. (ii) the surface plasmon / surface plasmon polariton stimulates interband transitions of electrons non participating in the oscillation (i.e. electrons not part of the plasmon) for instance via coupling of the surface plasmon to an existing exciton (electron-hole pair).

Bulk plasmons and bulk plasmon polaritons can work in the similar manner as the surface plasmons/polaritons as described in [0016].

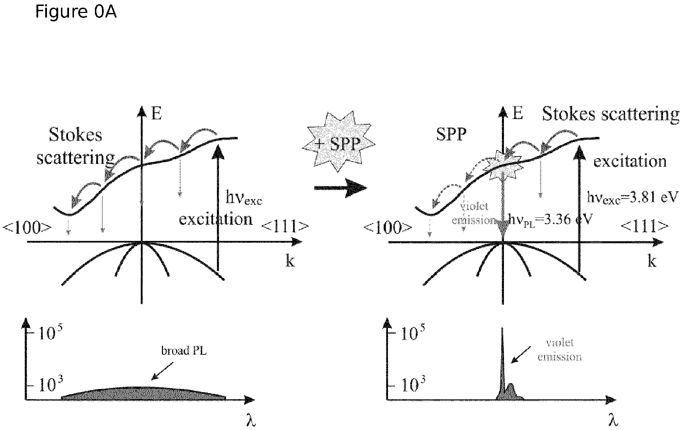

Figure 0A demonstrates one of the basic mechanisms of luminescence from Si resulting from surface plasmon polaritons. The figure will be discussed in more details further.

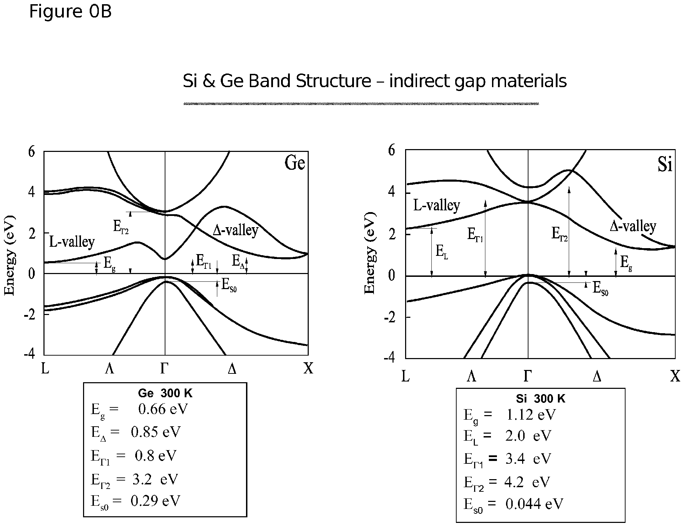

The most efficient luminescence is observed when the surface plasmon (excitation + electrons oscillation) is in resonance with an interband transition in Si or Ge - for instance E*_{Γ1}* transition, *E_{L}* transition, *E_{Γ2}* etc (see Figure 0B for reference).

Generally, the interfacing materials are Si (or Ge) and any of the following - vacuum (air), another semiconductor, a semi-metal, the n- or -p-doped Si (n- or p-doped Ge), Si oxide phase, Ge oxide phase etc. In this invention disclosure, the interfacing materials are primarily Si, Ge and any of the oxide phases of them.

There are several problems of importance for the Si-based industry solved by the invention:
*A*. Very efficient light emitter based on Si, Ge, their oxides, their n- or p-doped forms or other compatible materials forming interface with them. The light emission is present from helium (He) temperatures up to 50°C or perhaps to higher temperatures. Of importance is the light emission at room temperature (300°K), which is required for the telecom-, the computer manufacturing, the vision industries etc.
*B*. These materials and material combinations allow for least expensive light sources to be developed due to the fact that the Si-based technology is largely available and widely established, one the one hand, and the abundance of these materials in the nature, on another hand.
*C*. Such plasmon/polariton light emitter allows for its integration on a single platform along with a group-IV-based detector and a group-IV-based passive structure. The platform itself can be a Si wafer, which can simultaneously serve as source of light. Such integration brings enormous advantages in the areas of the computing, sensing, telecommunications, data processing, data encrypting etc. The single chip integration evokes reduction of device fabrication costs, increase of device functionalities, accelerates the speed of the device e.g. by avoiding copper interconnects in the present-day chips etc.
*D*. Miniaturization - the phenomena associated with plasmons and plasmon polaritons take place at length scales far below the diffraction limit of light. Thus, this type of devices circumvents the limits of the optical and the photonic devices. This fact allows for further miniaturization of the device dimensions.
*E*. The emission is typically very narrow and does not need filtering, which has advantages for many applications.

### BRIEF DESCRIPTION OF THE DRAWINGS

The following is a brief description of the figures wherein the definitions "material structure" and "structure" are equal. The fundamental materials considered in this invention, but not limited to, are as follows: (i) crystalline Si, intrinsic, n- or p-doped, (ii) crystalline Ge, intrinsic or n- or p-doped (iii) combination of Si and Ge, intrinsic or doped, (iv) a layer structure of Si (intrinsic, n- or p-doped) with its oxide phase (SiO, SiO_{0.5}, Si0₂ etc.), (v) a layer structure of Ge (intrinsic, n- or p-doped) with its oxide phase (GeO, GeO_{0.5}, GeO₂ etc.), (vi) a layer structure of any material mentioned in (i)-(v) with antimony (Sb) or other appropriate material. The materials are either in bulk form or in the form of thin layers. All the materials are to be understood as highly crystalline or monocrystalline.
Fig. 0A demonstrates the physical principle of light emission in Si in the absence of surface plasmon polariton SPP (conventional case) and in the presence of SPP.
Fig. 0B represents the electronic band structures of crystalline bulk Si and Ge.
Fig. 0C is an experimental result demonstrating light emission from monocrystalline Si.
Fig. 1 is a diagram, illustrating a material structure composed of simply bulk monocrystalline Si.
Fig. 2A is a diagram illustrating a two-layer structure Ge/Si.
Fig. 2B is a diagram illustrating a two-layer structure SiO/Si.
Fig. 2C is a diagram illustrating a two-layer structure SiO₂/Si.
Fig. 3A is a diagram illustrating a two-layer structure Ge/SiO_{0.5}.
Fig. 3B is a diagram illustrating a two-layer structure Si/SiO_{0.5}.
Fig. 4A is a diagram illustrating a two-layer structure Ge/SiO.
Fig.4B is a illustrating a two-layer structure Si/SiO.
Fig. 5A is a diagram illustrating a two-layer structure Ge/SiO₂.
Fig. 5B is a diagram illustrating a two-layer structure Si/SiO₂.
Fig. 6A is a diagram illustrating a two-layer structure GeO/Ge.
Fig. 6B is a diagram illustrating a two-layer structure GeO₂/Ge.
Fig. 7 is a diagram of a multilayer structure consisting of any combination of the above mentioned materials.
Fig. 8A is a diagram of a device based on one or more of the above mentioned materials. The diagram illustrates a device capable of light emission in UV, violet or visible spectral range when excitation of the structure by electrical mean i.e. bias is applied.
Fig. 8B is a diagram of a device based on one or more of the above mentioned materials. The diagram illustrates a device capable of light emission in UV, violet or visible spectral range when excitation of the structure by optical mean i.e. by light is applied.
Fig. 8C is a diagram of a device based on one or more of the above mentioned materials. The diagram illustrates a device capable of light emission in UV, violet or visible spectral range when excitation of the structure by electron beam is applied.
   Optical excitation or excitation by bias can be applied to a multilayer structure (Fig. 7) in the similar way as in Fig. 8A or Fig. 8B.
   The mentioned structures can be excited also by terahertz (THz) radiation.
Fig. 9 is a diagram illustrating a device, in which one of the above mentioned structures is placed in a resonator or a cavity for light amplification.
Fig. 10 is a table demonstrating the possibility to tune the emission wavelength by using different interfacing materials.

### DETAILED DESCRIPTION

The present invention will now be described with reference to the attached drawing figures, wherein like reference numerals are used to refer to like elements throughout, and wherein the illustrated structures and devices are not necessarily drawn to scale.

The light emitters in the present invention are based on a single-layer or bi-layer or a multi-layer material structure. The materials are monocrystalline, where applicable. The structure emits UV or visible light when excited electrically, optically, by an electron beam or by THz radiation. The size, shape and composition of the materials forming the structure(s) can be varied or adjusted to form different devices, properties or features.

Fig. 0A demonstrates the physical principle of light emission in crystalline bulk Si when light excitation is applied to the material. The method of band diagram is employed to explain the principle.

The left panel demonstrates the conventional process of light generation from Si in the absence of surface plasmon polariton. The process includes an electron-hole generation, Stokes scattering of the electrons and holes down to lower energy levels and relaxation of the electrons from the conduction band to the valence band accompanied with emission of broad band light. This process is well known, it is implemented in previously reported Si- and Ge-based light emitting devices and is given only for comparison.

The right panel demonstrates the physical principle of light generation from Si in the presence of surface plasmon polariton when light excitation of a wavelength λ=325 nm (photon energy of 3.81 eV) is applied. The process includes an electron-hole generation by an incident photon, scattering of the electrons down to lower energy levels via Stokes scattering toward the Si*E_{Γ1}* point where the surface plasmon polariton is generated. Further, the SPP decays with high rate light emission preventing further Stokes scattering to lower excitation energies. As a result, instead of the low-intensity emission in a wide spectral range in the course of Stokes scattering, an intense quasi-monochromatic light emission (3.36 eV) occurs.

Similar processes can be observed for other points of minimum local energy of the band structure if the frequency (equivalently the wavelength of the energy) of the SPP is tuned to that local minimum.

Similar processes are valid also for Ge, SiₓGe₁₋ₓ etc.

Fig. 0B demonstrates the energy band diagrams of crystalline Ge and Si. The figure is given as a reference.

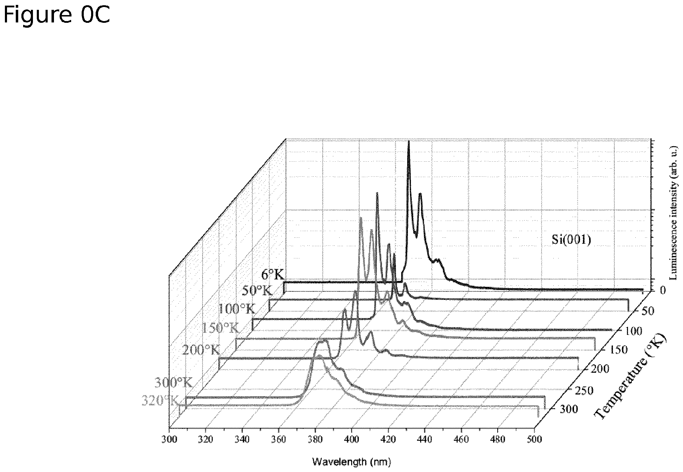

Fig. 0C is an experimental result demonstrating light emission from monocrystalline Si when a surface plasmon polariton is excited.

The following figures illustrate structures, in which generation of plasmons and plasmon polaritons is very efficient, which makes the structures and the materials building blocks of efficient plasmonic/polaritonic light emitters.

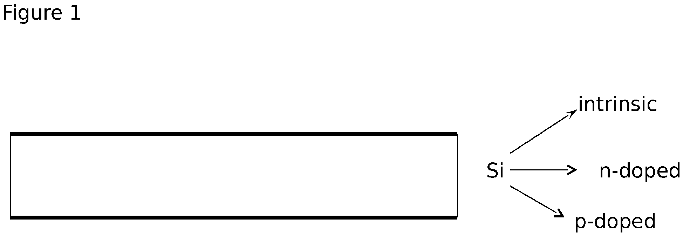

Fig. 1 is a diagram illustrating a structure from bulk crystalline or monocrystalline Si. The Si can be intrinsic or doped. The structure is capable of UV/visible light emission under electrical or optical excitation or under excitation by an electron beam or THz radiation.

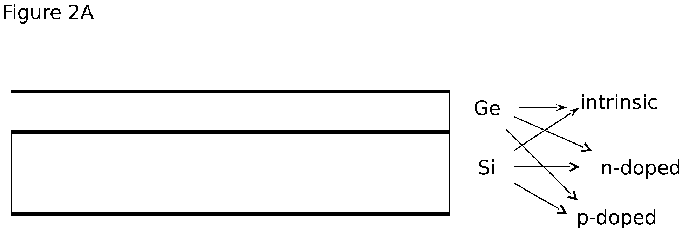

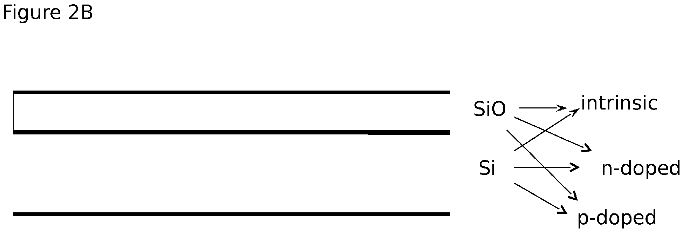

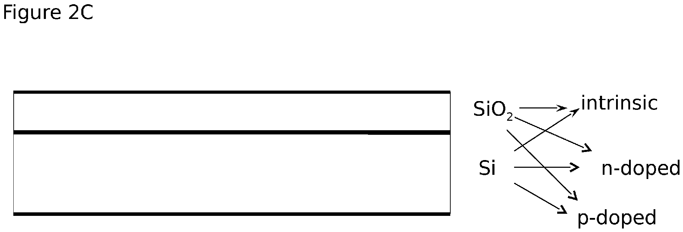

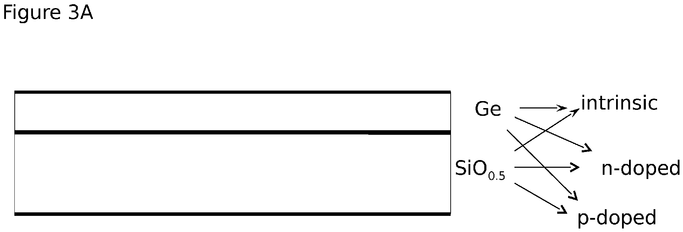

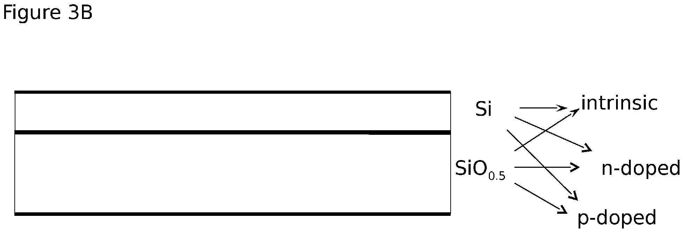

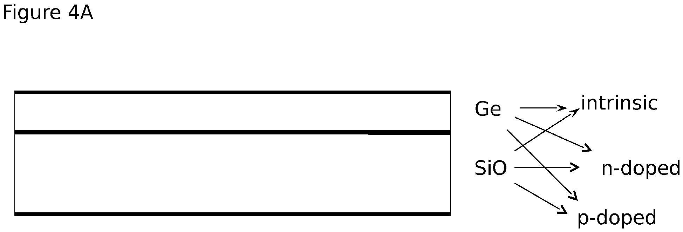

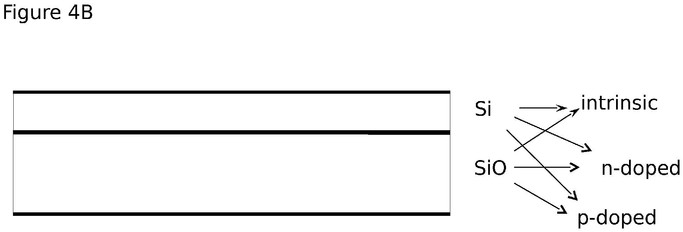

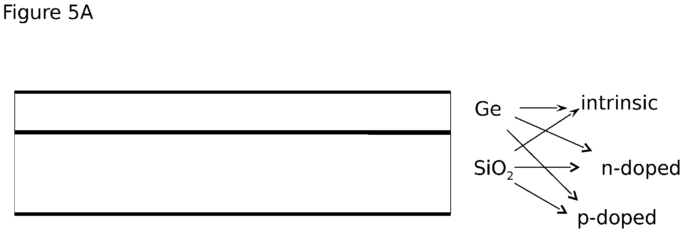

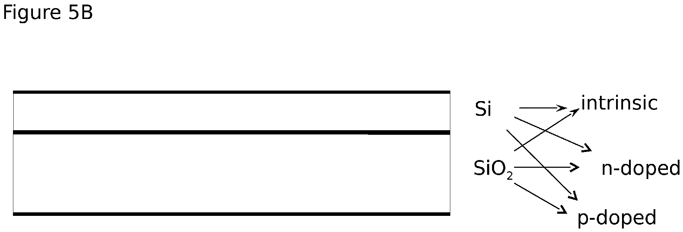

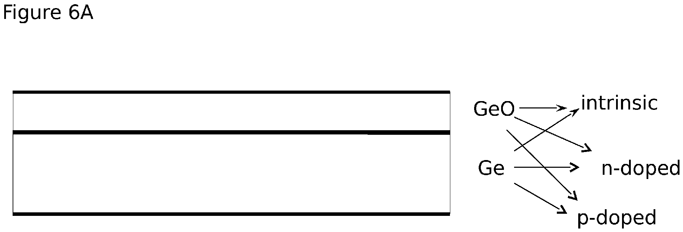

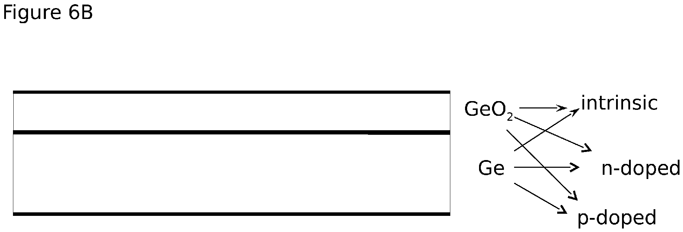

The bi-layer structures illustrated in Fig. 2A, Fig. 2B, Fig. 2C, Fig. 3A, Fig. 3B, Fig. 4A, Fig. 4B, Fig. 5A, Fig. 5B, Fig. 6A and Fig. 6B are capable of UV and/or visible light emission under electrical excitation (electroluminescence) or optical excitation (photoluminescence) or under excitation by an electron beam (cathodo-luminescence) or THz radiation. The structures are composed of crystalline or monocrystalline Si (undoped or doped), crystalline or monocrystalline Ge (undoped or doped) and their oxides in combinations as depicted in the figures.

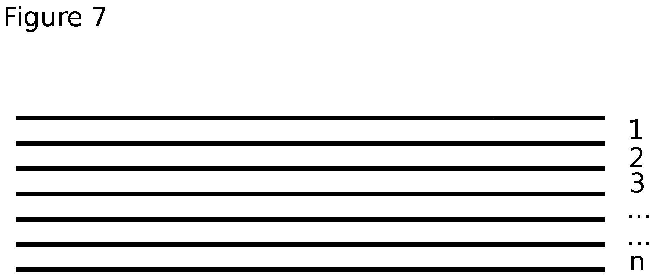

Fig. 7 is a diagram illustrating a multilayer structure composed of any combination of the following materials - Si, Ge, SiO, SiO2, SiO0.5, SiOx, where 0≤x≤2. Any layer of the multi-layer structure can be intrinsic or doped.

The doping can be p-type or n-type such as B (boron), Sb (antimony), P (phosphorous) or else. The doping is important for light emission even in the case of excitation of the structure(s) by optical beam or by electron beam. The doping changes the dielectric constant of the material, which in turn changes the spectral position of the plasmon and the plasmon polariton. Further, the doping can add free electrons, which further add to the surface plasmon or the surface plasmon polariton.

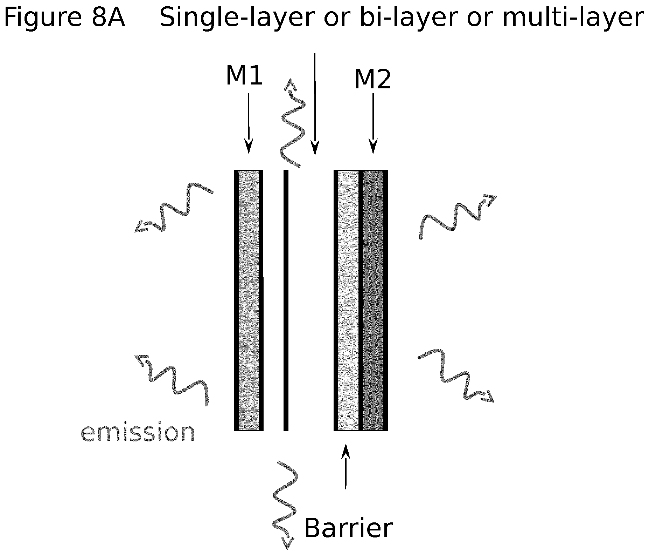

Fig. 8A is a diagram illustrating electrical excitation of a single-layer or bi-layer or multi-layer structure. The electrical excitation is done by means of application of bias. Electrode layers are deposited on both sides of the structure. The bias is applied to the electrodes. A barrier layer can be deposited between the electrode layer and the light emitting layer. In one example, the structure under electrical excitations is composed of the following layers ordered in a strict order: Cs (cesium) or Au (gold) electrode layer/ emitting material/LaGdO₃ barrier layer/ LaB₆ electrode layer. In another example, the structure under electrical excitations is composed of the following layers ordered in a strict order: Cs (cesium) or Au (gold) electrode layer/ emitting material/LaBaO₃ barrier layer/ LaB₆ electrode layer. The metals Cs and Au are selected due to their low work functions necessary in the electric excitation. In another example, other materials can be used as electrode layers and barrier layer. Unlike the conventional p-n, p-i-n or other junctions known to date, the presented structures in Fig. 7A generates light also by undoped materials and only when surface or/and bulk plasmons or plasmon polaritons are present (generated) in the material(s).

The generation of the surface plasmons, surface plasmon polaritons, bulk plasmons and/or bulk plasmon polaritons occurs simultaneously with the excitation bias/beam/radiation.

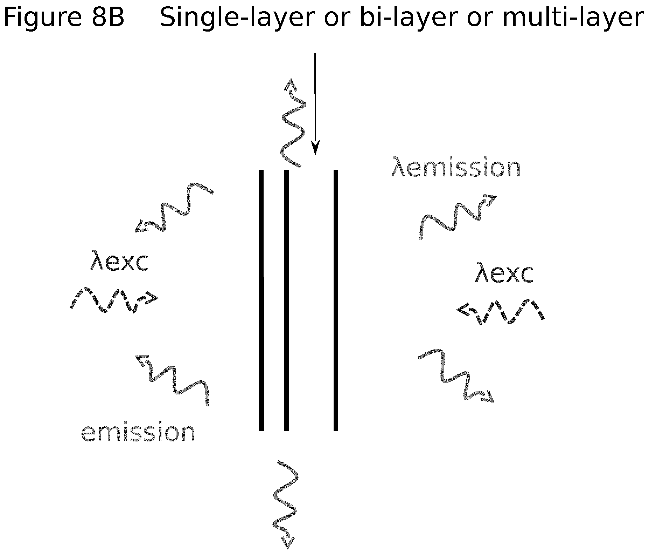

Fig. 8B is a sketch showing excitation of the structure by optical mean. In one example, the excitation source is a light source of a smaller wavelength as comparison to the wavelength of the emission from the structure (λ_{excitation}<λₑₘᵢₛₛᵢₒₙ). In another example, the excitation source is a broad band light source having UV (ultraviolet) components in its light spectrum.

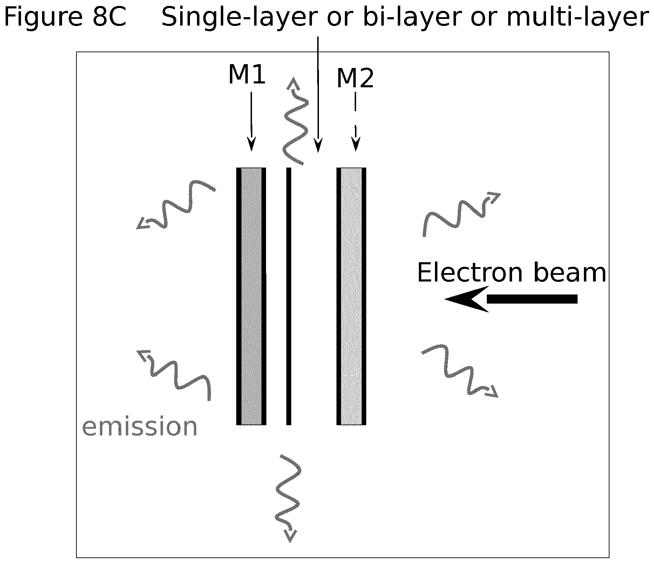

Fig. 8C is a sketch showing excitation of the structure by an electron beam. The structure is capable of light emission of UV and visible light under bombardment of the material (structure) by an electron beam. An electrode layer/structure can be deposited on the back surface or/and the front surface of the structure required for this type of excitation. In another example, the material structure is placed on a metal support playing the role of the electrode. Yet in another example, the electrode may be placed away from the material structure. The purpose of the electrode is to accelerate the electron beam (emitted from a cathode electrode) toward the material structure.

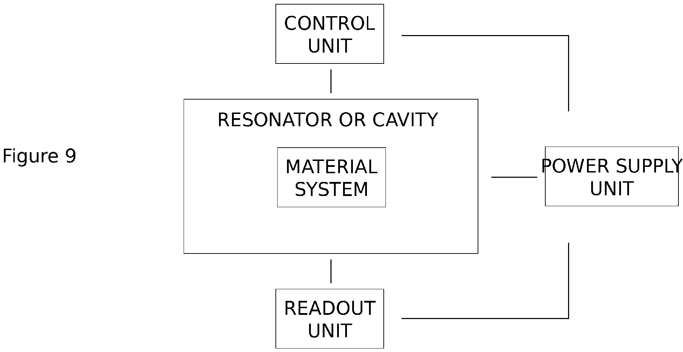

Fig. 9 illustrates a device, wherein the emitting structure named "material system" is placed in a resonator or a cavity. The purpose of the resonator/the cavity is to amplify the light emitted from the structure. In one example, the resonator or the cavity is tuned to amplify the ∼ 370 nm light emitted from crystalline Si observed from Si(001) as in Fig. 0C.

The device also includes one or more additional units such as a control unit, a power supply unit and a readout unit. Additional unit may be the excitation source.

The material system in Fig. 8C and Fig. 9 may be placed in vacuum environment.

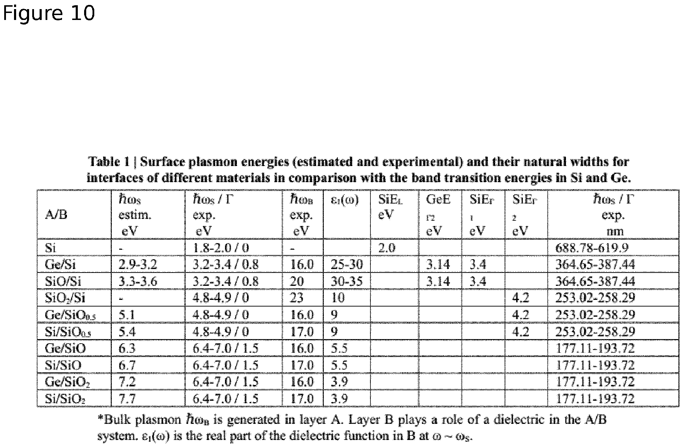

Tuning the emission wavelength: The table of Fig. 10 is an experimental demonstration of how to tune the wavelength (the color) of the emission associated with surface plasmons. By appropriate choice of interfacing materials, surface plasmons of different energies (thus, wavelength) at the interfaces are generated. The decay of the surface plasmons leads to emission of light. If the surface plasmon is coupled to a band transition and forms a surface plasmon polariton, the efficiency of the emission increases drastically.

## Claims

1. A material structure comprising one or more monocrystalline or annealed polycrystalline layers of the following structures able to emit ultra-violet or visible light:
Silicon (Si);
Germanium/Silicon (Ge/Si)
Silicon monoxide/Silicon (SiO/Si)
Silicon dioxide/Silicon (SiO₂/Si)
Germanium/Silicon oxide 0.5 (Ge/SiO_{0.5})
Silicon/Silicon oxide 0.5 (Si/SiO_{0.5})
Germanium/Silicon monoxide (Ge/SiO)
Silicon/Silicon monoxide (Si/SiO)
Germanium/Silicon dioxide (Ge/SiO₂)
Silicon/Silicon dioxide (Si/SiO₂)
Germanium oxide/Germanium (GeO/Ge)
Germanium dioxide/Germanium (GeO₂/Ge)
Any phase of the oxide SiOx in interface with Si or Ge, where 0≤x≤1
Any phase of the oxide GeOx in interface with Si or Ge, where 0≤x≤1.
Metal layer on Si or Ge.

2. A material system including one or more layers/bi-layers of claim 1 in combination with metal layers or metal structures and barrier layers for electrical excitation,
The metal layer or structure can be on one side of the material system or on both sides of the material system and serves as an electrode,
The barrier layer is a layer, usually a dielectric or semiconductor material, building a band offset with the neighbouring metal layer and the layer of the material of claim 1.

3. A system comprising:
**A source unit** which:
Can supply voltage to the active unit;
Can supply current to the active unit;
**An active unit** containing one or more layers of the materials of claim 1 configured to emit light in the UV or visible spectral range depending upon the material, its doping and depending on the interface it forms with another layer;
The system may also include
**A detector unit** which detects the emitted UV or visible light;
**A passive unit**, which captures the light from the active unit and makes use of it or guides the emitted light to the detector unit.

4. A system comprising:
**A light source** unit which:
Supplies excitation light with a broad band spectrum partially containing UV light;
Supplies excitation light of narrow band such as light emitting diode (LED) or a laser diode or a laser of another type;
**An active unit** containing one or more layers of the materials of claim 1 configured to emit light in the UV or visible spectral range depending upon the material, its doping and depending on the interface it forms with another layer;
The system may also include
**A detector unit** which detects the emitted UV or visible light;
**A passive unit**, which captures the light from the active unit and makes use of it or guides the emitted light to the detector unit.

5. A system comprising:
**A source unit** which:
Supplies an electron beam for excitation of the structure;
**An active unit** containing one or more layers of the materials of claim 1 configured to emit light in the UV or visible spectral range depending upon the material, its doping and depending on the interface it forms with another layer;
The system may also include
**A detector unit** which detects the emitted UV or visible light;
**A passive unit**, which captures the light from the active unit and makes use of it or guides the emitted light to the detector unit.

6. The system of claims 1, 2, 3 or 4 further comprising a resonator or a cavity to amplify the emitted light. The device may include one or more units from the following: a power supply unit, a control unit and a readout unit.

7. The system of claims 1 through 6 wherein the system may be incorporated in a vacuum environment.

8. The light emission occurs with the assistance of one or more of the following quasi-particles: surface plasmons, surface plasmon polaritons, bulk plasmons and/or bulk plasmon polaritons.

9. More general significance of the revealed effect in this invention disclosure might be as follows. Since the plasmon energies in semiconductors and dielectrics like SiOx can be varied by changing the chemical composition, there appears the opportunity to design the resonances between SPPs and transitions in different semiconductors and dielectrics at the high density of states points (dE/dk ∼ 0). Thus, the new-type light emission under photons or electrons can be engineered in different materials. For example, activation of the EΓ2 transition in Ge should be expected due to assistance from the SPP generated on the Ge/Si interface.

10. The modification of the energy of the surface plasmons in Si, Ge, SiₓGe₁₋ₓ can be obtained with other interfacing material as well like metal (Ag, Au, Cr) but also with SiC (silicon carbide, graphite) etc... The modification of the energy of the surface plasmon finally means modification of the emission wavelength. This means, light sources at different wavelengths can be obtained.

11. In the process of excitation of plasmons and plasmon polaritons, valence band electrons or conduction band electrons can participate. Or both simultaneously.
